(19) Europäisches Patentamt
European Patent Office
Office européen des brevets

(11) Veröffentlichungsnummer: **0 281 550**
**B1**

(12) # EUROPÄISCHE PATENTSCHRIFT

(45) Veröffentlichungstag der Patentschrift: **22.08.90**

(51) Int. Cl.$^5$: **H 03 K 21/40,** G 01 C 22/02

(21) Anmeldenummer: **86903244.1**

(22) Anmeldetag: **13.06.86**

(86) Internationale Anmeldenummer:
**PCT/DE86/00245**

(87) Internationale Veröffentlichungsnummer:
**WO 87/01884 26.03.87 Gazette 87/07**

(54) **SCHALTUNGSANORDNUNG ZUR ADDITION, SPEICHERUNG UND WIEDERGABE ELEKTRISCHER ZÄHLIMPULSE.**

(30) Priorität: **13.09.85 DE 3532768**

(43) Veröffentlichungstag der Anmeldung:
**14.09.88 Patentblatt 88/37**

(45) Bekanntmachung des Hinweises auf die Patenterteilung:
**22.08.90 Patentblatt 90/34**

(84) Benannte Vertragsstaaten:
**DE FR GB IT SE**

(56) Entgegenhaltungen:
**EP-A-0 067 364**
**EP-A-0 067 925**
**EP-A-0 139 770**
**FR-A-2 551 202**

(73) Patentinhaber: **ROBERT BOSCH GMBH**
**Postfach 50**
**D-7000 Stuttgart 1 (DE)**

(72) Erfinder: **BAUER, Harald**
**Chamerstrasse 25**
**D-8500 Nürnberg (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

EP 0 281 550 B1

## Beschreibung

Stand der Technik

Die Erfindung geht aus von einer Schaltungsanordnung zur Addition, Speicherung und Wiedergabe einer Anzahl von elektrischen Zählimpulsen nach der Gattung des Hauptanspruchs.

Bei einer solchen bekannten Schaltungsanordnung (EP—A—67 925) werden die Zählimpulse in einem mehrstelligen dekadischen Zählwerk eingelesen und von dort in einen nichtflüchtigen, überschreibbaren dekadischen Speicher übertragen. Da dieser Speicher für den Einsatz von Kilometerzählern in Kraftfahrzeugen eine große Speicherzeit von mindestens 10 Jahren sowie einen Arbeitstemperaturbereich von −25°C bis +70°C aufweisen, muß, werden bei der bekannten Schaltungsanordnung Floating-Gate-Speicherzellen verwendet, die jedoch mit einer zunehmenden Anzahl von Löschvorgängen zunehmend längere Löschzeiten benötigen. Ähnliche Probleme ergeben sich bei der Verwendung anderer sogenannter EEPROM's als Speicher, bei denen ebenfalls die Anzahl der Löschungen den Wert von 10 000 nicht überschreiten sollte.

Zur Begrenzung der Löschvorgänge an den einzelnen Speicherzellen ist bei der bekannten Schaltungsanordnung jede Dekade des mehrdekadischen Zählers aus einem 5-bit-Schieberegister aufgebaut und die einzelnen Zählimpulse werden in einem einschrittigen Code, vorzugsweise mit dem Libraw-Craig-Code in die Einer-Dekade eingelesen. Jeder 10. Zählimpulse wird nach dem gleichen Code in die Zehner-Dekade, jeder 100. Zählimpuls in die Hunderter-Dekade usw. eingelesen. Der an dem mehrdekadischen Zähler angeschlossene Speicher ist ebenfalls mehrdekadisch aufgebaut, um die Zählimpulse mit dem gleichen einschrittigen Code darin abspeichern zu können. Um die Zahl der Löschvorgänge des nichtflüchtigen Speichers in den niedrigen Dekaden möglichst gleichmäßig zu verteilen, werden die niedrigen Dekaden des Speichers in ihrer Zuordnung zu den niedrigen Dekaden des Zählers zyklisch in Abständen von beispielsweise 100 000 Kilometer vertauscht.

Diese Lösung hat jedoch den Nachteil, daß beim Ausfall einer Speicherzelle der damit auftretende Fehler in der Kilometeranzeige so beträchtlich sein kann, daß der angezeigte Werte keinen Rückschluß mehr auf den tatsächlichen Zählerstand zuläßt. Tritt ein solcher Fehler beispielsweise in den höheren Dekaden des Speichers an der zuletzt beschriebenen Speicherzelle oder an der davorliegenden Speicherzelle auf, so können die Abweichungen 100, 1000, 10 000 oder 100 000 Kilometer betragen.

Bei einer weiteren, aus der EP—A—139 770 bekannten Schaltungsanordnung für einen Kilometerzähler in Kraftfahrzeugen ist ein Zählspeicher aus einer Anzahl N gleichgroßen, nichtflüchtigen Speicherregistern vorgesehen, in die jeweils fortlaufend nach jeder Teilstrecke der vollständige Kilometerstand zyklisch eingeschrieben wird. Dies hat den Nachteil, daß praktisch N-mal ein 16×16—EEPROM benötigt wird, ohne daß dadurch die Lösch— und Schreibvorgänge in sämtlichen Speicherzellen reduziert werden Außerdem bietet diese Lösung eine ausreichende Sicherheit gegen auftretende Fehler beim Löschen oder Überschreiben eines der Speicherregister. Ein solcher fehlerhafter Wert wird zwar zunächst von der Schaltung nicht zur Anzeige gebracht, der falsche Wert wird aber nicht gelöscht sodern auf ihn werden die weiteren Entfernungsabschnitte zur Ermittlung der totalen Fahrstrecke aufaddiert. Der Fehler pflanzt sich somit fort.

Mit der vorliegenden Lösung wird angestrebt, einen nichtflüchtigen, überschreibbaren Speicher in der Form aufzubauen, daß einerseits die Schreib- und Löschvorgänge an den einzelnen Speicherzellen innerhalb des geforderten Zeitraumes im Rahmen der zulässigen Grenzen bleiben und daß darüber hinaus beim Auftreten eines Fehlers an einer Speicherzelle die Abweichung des Speicherinhaltes vom richtigen Wert die kleinste Zähleinheit nicht überschreitet.

Vorteile der Erfindung

Die erfindungsgemäße Schaltungsanordnung mit den kennzeichnenden Merkmalen des Hauptanspruchs hat den Vorteil, daß mit einem relativ kleinen überschreibbaren, nichtflüchtigen Speicher durch den gewählten einschrittigen Code ein elektronischer Zähler, z.B. ein Kilometerzähler für Kraftfahrzeuge mit sehr langer Lebensdauer und hoher Genauigkeit realisiert werden kann, indem mit jedem neuen Zählimpuls umlaufend jeweils nur eines der Speicherregister um eine Einheit modifiziert wird. Durch das umlaufende Ansprechen aller Register werden die Löschvorgänge an den einzelnen Speicherzellen des gesamten Speichers gleichmäßig verteilt. Als weiterer Vorteil ist anzusehen, daß sich durch dieses Speicherverfahren eine hohe Redundanz ergibt, da der Ausfall einzelner Speicherzellen nicht mehr zum Totalausfall des gesamten Zählers führen kann. Vielmehr führt mit der vorliegenden Lösung die Anzahl fehlerhafter Speicherplätze im ungünstigsten Falle zu einem um die gleiche Anzahl fehlerhaften Zählerstand.

Durch die in den Unteransprüchen aufgeführten Maßnahmen sind vorteilhafte Weiterbildungen und Verbesserungen der im Hauptanspruch angegebenen Merkmale möglich. Dabei ist es besonders zweckmäßig, z.B. für einen Kilometerzähler eines Kraftfahrzeuges als Speicher ein 16×16 EEPROM zu wählen, welches in 16 Registern mit je 16 Speicherplätzen (bit) aufgegliedert und über Leitungen mit der Steuerschaltung sowie einer Datenein- und -ausgabeeinheit verbunden ist. Die Zählimpulse werden dabei von der Steuerschaltung nach einem Binärcode in die einzelnen Register eingeschrieben. In vorteilhafter Weise ist dabei die Steuerschaltung sowie die Datenein- und -ausgabeeinheit in einem Mikrocomputer zusammengefaßt.

Zeichnung

Ein Ausführungsbeispiel mit weiteren Einzelheiten der Erfindung ist in der Zeichnung dargestellt und in der nachfolgenden Beschreibung näher erläutert. Es zeigen Figur 1 die erfindungsgemäße Schaltungsanordnung eines elektronischen Zählers im Blockschaltbild, Figur 2 eine Tabelle mit dem Registerinhalt in Abhängigkeit von den Zählimpulsen, Figur 3 zeigt eines der Speicherregister und dessen Inhalt, Figur 4 zeigt ein Flußdiagramm für die Eingabe in den Speicher und Figur 5 zeigt ein Flußdiagramm für das Auslesen und Anzeigen des Speicherinhaltes.

Beschreibung des Ausführungsbeispieles

Die erfindungsgemäße Schaltungsanordnung ist gemäß Figur 1 für einen Kilometerzähler eines Kraftfahrzeugs mit einem Weggeber 10 versehen, der nach jedem Teilabschnitt einer vom Fahrzeug zurückgelegten Wegstrecke einen elektrischen Impuls erzeugt. Über eine Anschlußleitung 11 des Weggebers gelangen diese auf einen Vorteiler 12, welcher gemeinsam mit einer Steuerschaltung 13 und einer Datenein- und -ausgabeeinheit 14 in einem Mikrocomputer 15 zusammengefaßt ist. Der Vorteiler 12 wird in Abhängigkeit vom Fahrzeugtyp bzw. von der Radgröße des Fahrzeugs auf die Zahl eingestellt, die der Impulszahl des Weggebers 10 beim Abfahren einer Wegstrecke von zwei Kilometern im Beispielsfall (oder von einem Kilometer) entspricht. Die Schaltungsanordnung umfaßt ferner einen überschreibbaren, nichtflüchtigen Speicher 16 in Form eines 16×16 EEPROM sowie ein Display 17 in Form einer LCD-Anzeige. Speicher 16 und Display 17 sind über Steuerleitungen 18, 18a, 18b mit dem Vorteiler 12, der Steuerschaltung 13 und der Datenein- und -ausgabe 14 verbunden. Der Speicher 16 ist in 16 Speicherregister 19 mit je 16 Speicherplätzen (bit) aufgegliedert, wobei die Speicherregister 19 von 0 bis 15 durchnumeriert sind. Das Register 15 (rechtes Speicherregister 19) dient lediglich zur Rettung des Zählerstandes im Vorteiler 12 beim Ausfall der Versorgungsspannung an der Plusklemme 20 (z.B. beim Abklemmen der Batterie des Kfz) des Mikrocomputers 15 über die Steuerleitung 18b. Über einen nicht dargestellten Pufferkondensator wird dabei die Spannungsversorgung für die Datenrettung gewährleistet. Sobald der Mikrocomputer wieder an seine Versorgungsspannung geschaltet wird, werden die geretteten Daten aus dem Register 15 wieder in den Vorteiler 12 zurückgegeben. Die am Ausgang des Vorteilers 12 auftretenden elektrischen Zählimpulse werden über die Steuerleitung 18 mit Hilfe der Steuerschaltung 13 auf den Speicher 16 gegeben und dort mit einer angedeuteten Ringsteuerung 21 in einem einschrittigen Code gezählt und abgespeichert. Außerdem wird der Inhalt des Speichers 16 als codierte Summe der gespeicherten Zählimpulse zyklisch mit Hilfe der Steuerschaltung 13 ausgelesen sowie auf dem Display 17 optisch angezeigt. Dafür ist im Mikrocomputer 15 u.a. noch ein Zwischenspeicher 22 vorgesehen.

Mit Hilfe der Figur 2 soll nunmehr der Code näher erläutert werden, nach dem die einzelnen Zählimpulse in die Register 0 bis 14 des Speichers 16 eingeschrieben werden. Wie Figur 3 zeigt, ist dabei jedes der 16 Speicherregister 19 mit je 16 Speicherplätzen versehen. Im Ausgangszustand sind sämtliche Speicherplätze mit der Information 1 versehen. Zum besseren Verständnis ist jedoch in den Figuren 2 und 3 der Ausgangszustand des Speichers in allen Speicherzellen mit dem Inhalt 0 angenommen (invertiert). Folglich stehen gemäß Figur 2 zunächst sämtliche Register auf Null. Sobald nun am Ausgang des Vorteilers 12 nach einer Fahrstrecke von zwei Kilometern ein erster Zählimpuls auftritt, wird dieser über die Steuerleitung 18 auf den Speicher 16 gegeben. Dort sind zunächst sämtliche Registereingänge mit Ausnahme des Registers 14 gesperrt, so daß dieser Zählimpuls zunächst nur in das Register 14 eingelesen wird. Danach wird das Register 13 geöffnet und das Register 14 wird zusammen mit den übrigen Speicherregistern 19 gesperrt. Nach weiteren zwei Kilometern wird nun der nachste Zählimpuls in das Register 13 eingelesen. Danach wird der Registereingang gesperrt und der Eingang des Registers 12 für den dritten Zählimpuls freigegeben. Die jeweils gesperrten Speicherregister 19 behalten folglich ihren Inhalt bei. Mit dem 15. Zählimpuls ist auch das letzte Speicherregister 19 (Register 0) angesprochen und hat nunmehr ebenfalls wie die vorherigen Speicherregister den Inhalt 1. Gleichzeitig wird nun der Eingang des ersten Speicherregisters 19 (Register 14) wieder freigegeben und mit dem 16. Zählimpuls wird der Inhalt des Registers 14 um eine Einheit auf 2 erhöht. In gleicher Weise werden jetzt sukzessive auch die übrigen Speicherregister 19 um eine Zähleinheit erhöht.

Durch einen solchen einschrittigen Code wird gewärleistet, daß die Steuerschaltung 13 beginnend mit dem ersten Speicherregister 19 jeden neuen Zählimpuls in das nächstfolgende Speicherregister 19 einschreibt und nach dem Erreichen des letzten Register (Register 0) mit den nächsten Zählimpulsen den Inhalt des ersten und danach des jeweils nächstfolgenden Speicherregisters 19 um je eine Einheit erhöht. Aus Figur 3 ist dabei erkennbar, daß die Steuerschaltung 13 die Zählimpulse nach einem binären Code, dem Dualcode, in die einzelnen Speicherregister 19 einschreibt. So sind nach dem 43. Zählimpuls (Figur 2) die Speicherzellen 1 und 2 der Register 2 bis 14 mit der Information 1 belegt, wobei die vierzehn übrigen Speicherzellen (3 bis 16) dieser Register den Inhalt 0 haben. Nach dem Dualcode entspricht dies dem Wert 3, wogegen die Register 0 und 1 noch den Wert 2 haben (Figur 2).

Mit Hilfe des in Figur 4 dargestellten Flußdiagramms soll nunmehr das Einschreiben von Zählimpulsen in den Speicher 16 bzw. in das jeweils richtige Speicherregister 19 näher erläutert werden. Dabei gilt:

j=Zeiger für angesprochenes Register
n=Zahl der ansprechbaren Register=15
e=Inhalt des angesprochenen Registers

Reg=angesprochenes Register.

Im Ausgangszustand zeigt dabei der Registerzeiger j auf das vordere Register 0 und der Inhalt e der Register ist ebenfalls 0.

Mit dem Auftreten eines Zählimpulses $I_z$ wird nun im ersten Programmschritt 30 der Registerzeiger j um 1 dekrementiert. Danach wird im Schritt 31 geprüft, ob der Registerzeiger j nun den Wert 0 unterschritten hat. Da dies beim Start der Fall ist, wird im Schritt 32 de Registerzeiger j auf das Register 14 gestellt (j=n−1; n=15). Im Schritt 33 wird nun der bisherige Inhalt e (0) um den Wert 1 erhöht und im Schritt 34 wird dieser neue Inhalt e in das angesprochene Register 14 eingeschrieben.

Mit einem weiteren Zählimpuls wird zunächst der Schritt 30 durchlaufen, wobei der Registerzeiger j nunmehr auf 13 gesetzt wird. Im Schritt 31 wird festgestellt, daß dieser Wert größer Null ist, so daß mit einem Programmsprung 29 nunmehr unmittelbar im Schritt 34 der Inhalt e des zuletzt beschriebenen Registers 14 in das nunmehr angesteuerte Register 13 (Reg. j) eingeschrieben wird. Dieser Vorgang wiederholt sich solange, bis auch das Register 0 den Inhalt e=1 hat. Mit dem nachfolgenden Zählimpuls $I_z$ wird nunmehr der Registerzeiger j im Schritt 30 unter Null dekrementiert und im Schritt 32 wird er nunmehr erneut auf das Register 14 (j=15−1) gestellt. Im Schritt 33 und 34 wird dessen Inhalt um 1 erhöht. Mit weiteren Zählimpulsen werden nunmehr auch die übrigen Speicherregister 19 schrittweise mit dem neuen Inhalt e versehen und auf diese Weise die Summe der auf den Speicher 16 gelangenden Zählimpulse $I_z$ gebildet.

Die Anzeige des Kilometerzählers bzw. das Auslesen des Speicherinhaltes erfolgt mit einem in Figur 5 dargestellten Flußdiagramm, wobei die letzte Stelle der LCD-Anzeige sowie die Stelle hinter dem Komma der Kilometeranzeige in Verbindung mit dem Vorteiler 12 des Mikrocomputers 15 in nicht dargestellter Weise ermittelt wird. Zur Ermittlung des Speicherinhaltes ist es wesentlich, das jeweilige Speicherregister 19 im Speicher 16 zu ermitteln, in das der letzte Zählimpuls abgespeichert wurde. Wie Figur 2 zeigt, ist das jeweils an der Stelle, an der die davorliegenden Speicherregister 19 (mit kleinerer Adresse) einen um 1 geringeren Inhalt haben als alle übrigen Register. Um dieses Speicherregister 19 herauszufinden, wird zunächst mit einem ersten Durchlauf des Flußdiagramms nach Figur 5 der Inhalt des ersten Registers 14 mit den Inhalten der übrigen Register verglichen. Danach wird in einem weiteren Durchlauf des Flußdiagramms in Figur 5 das nächste Register 13 mit den übrigen Registern verglichen, so daß die Steuerschaltung 13 schrittweise fortschreitend den Inhalt jeweils eines der Speicherregister 19 als Bezugsregister mit dem Inhalt der übrigen Speicherregister als Vergleichsregister beginnend mit dem ersten und abschließend mit dem letzten Speicherregister 19 vergleicht. Dabei wird der Inhalt derjenigen Vergleichsregister, die nach dem Bezugsregister angeordnet sind mit einem um eine 1 dekrementierten Inhalt des Bezugsregisters verglichen. Schließlich wird bei jedem Programmdurchlauf zu jedem Bezugsregister die Summe der Übereinstimmungen bei den Inhaltsvergleichen gebildet und zwischengespeichert. Ferner wird die Summe der Übereinstimmungen die dem letzten aufgerufenen Bezugsregister zugeordnet ist, mit der Summe der Übereinstimmungen vorheriger Bezugsregister verglichen und schließlich dasjenige Bezugsregister mit der maximalen Übereinstimmungssume ermittelt. Die maximale Übereinstimmungssumme von 15 wird jeweils mit dem Bezugsregister erreicht, in das der letzte Zählimpuls eingeschrieben wurde. Über den Inhalt des so ermittelten Bezugsregisters kann nunmehr vom Mikrocomputer 15 die Summe der erfaßten Zählimpulse $I_z$ ermittelt und damit der Zählerstand errechnet und angezeigt werden. Mit dem Flußdiagramm nach Figur 5 soll beispielsweise der Inhalt des Speichers 16 nach dem 43. Zählimpuls ausgelesen und angezeigt werden. Dabei haben die Register 0 und 1 jeweils den Inhalt 2 und die übrigen Register 2 bis 14 haben den Inhalt 3 (Figur 2).

Für die Erläuterung des Flußdiagrammes der Figur 5 gilt:

i=Zeiger für Bezugsregister
$e_i$=Inhalt des Bezugsregisters
a=Vergleichsinhalt
k=Zeiger für Vergleichsregister
$e_k$=Inhalt des Vergleichsregisters
j=Zeiger für Register mit maximaler Übereinstimmung
z=Übereinstimmungszähler
$Z_{max}$=Maximumzähler
x=Speicherinhalt (=berechneter Zählerstand)

Zur Ermittlung des Speicherinhalts wird nun in einem ersten Programmschritt ein Maximumzähler ($Z_{max}$) im Zwischenspeicher 22 des Mikrocomputers 15 auf Null gesetzt und im Schritt 36 wird der Zeiger i für das zum Vergleich ausgewählte Bezugsregister auf n−1=14 gesetzt, wobei die Zahl der anzuwählenden Register n=15 ist. Im Schritt 37 wird ein Übereinstimmungszähler Z=0 gesetzt und im Schritt 38 wird der Inhalt $e_i$ des Bezugsregisters als Vergleichsinhalt a zwischengespeichert. Im vorliegenden Fall ist dies beim Register 14 der Inhalt 3. Im Schritt 39 wird nun ein Zeiger k für ein Vergleichsregister ebenfalls auf 14 gesetzt, damit bildet das Register 14 zunächst sowohl das Bezugsregister als auch das Vergleichsregister. Im Schritt 40 wird daher festgestellt, daß der Inhalt $e_k$ des Vergleichsregisters mit dem Vergleichsinhalt a übereinstimmt. Im Schritt 41 wird nun der bisherige Inhalt (Z=0) des Übereinstimmungszählers Z um 1 erhöht und im Schritt 42 wird geprüft, ob der Zähler k für das Vergleichsregister mit dem Zählerstand i des Bezugsregisters übereinstimmt. Da dies im vorliegenden Fall zutrifft, wird im Schritt 43 der bisherige Vergleichsinhalt a=3 um 1 dekrementiert, um nur für den Fall eine maximale Übereinstimmungssumme zu bekommen, in dem alle davorliegenden Vergleichsregister (Register 0 bis 13) einen um 1 kleineren Inhalt haben. Im Schritt 44

wird der Zeiger k für das Vergleichsregister um 1 dekrementiert, so daß nunmehr das Register 13 als Vergleichsregister herangezogen wird. Im Schritt 45 wird geprüft, ob der Zeiger k für das Vergleichsregister noch nicht unter Null steht. Da dies noch nicht der Fall ist, werden nunmehr in einer Schleife 28 die Schritte 40 bis 44 erneut durchlaufen.

Da jedoch der Inhalt $e_k$ des Registers 13 mit dem neuen Vergleichsinhalt a=2 nicht übereinstimmt, wird nach dem Schritt 40 der Übereinstimmungszähler Z nicht erhöht, indem der Schritt 41 übersprungen wird. Da außerdem jetzt das Vergleichsregister 13 nicht mehr mit dem Bezugsregister 14 übereinstimmt, wird auch der Schritt 43 übersprungen und im Schritt 44 wird der Zeiger k für das Vergleichsregister auf 12 gestellt. Mit dem Schritt 45 wird nun erneut die Schleife 28 mit den Schritten 40 bis 44 für das Vergleichs register 12 durchlaufen und ebenfalls keine Übereinstimmung mit dem Vergleichsinhalt festgestellt. Das gleiche wiederholt sich bei den Vergleichsregistern 11, 10...bis 2, wonach nun der Zeiger k für das Vergleichsregister auf 1 gestellt wird. Über den Schritt 45 wird nunmehr nochmals die Schleife 28 mit den Schritten 40 bis 44 durchlaufen, wobei jedoch jetzt der Inhalt $e_k$ des Vergleichsregisters mit dem Vergleichsinhalt a=2 übereinstimmt. Im Schritt 41 wird nun folglich der Übereinstimmungszähler Z um 1 auf 2 erhöht. Auch im letzten Schleifendurchlauf mit dem Register 0 als Vergleichsregister wird Übereinstimmung festgestellt und der Zähler Z wird somit auf 3 erhöht. Im Schritt 45 wird jetzt die Schleife verlassen und im Schritt 46 wird der Inhalt des Übereinstimmungszählers Z mit dem zuvor auf 0 gesetzten Maximumzähler $Z_{max}$ verglichen und ein neues Übereinstimmungsmaximum festgestellt. Im Schritt 47 wird nun der Inhalt des Übereinstimmungszählers Z in den Maximumzähler übernommen und im Schritt 48 wird der Zeiger i des Bezugsregisters als Zeiger j für das Register mit der maximalen Übereinstimmungssume zwischengespeichert.

Im Schritt 49 wird nun der Zeiger i für das Bezugsregister um 1 dekrementiert und im nachfolgenden Schritt 50 wird geprüft, ob bereits sämtliche Speicherregister 19 als Bezugsregister aufgerufen worden sind. Solange dies noch nicht der Fall ist, wird jeweils das nächst vordere Speicherregister 19 als neues Bezugsregister durch den Bezugsregisterzeiger i angewählt und über eine Schleife 51 wird dann auf den Programmschritt 37 des Flußdiagramms nach Figur 5 zurückgesprungen.

Beim erneuten Durchlauf des Flußdiagramms wird folglich jetzt das Register 13 als Bezugsregister mit den übrigen Speicherregistern 19 verglichen und dabei im Übereinstimmungszähler Z die Anzahl der Übereinstimmungen dieser Vergleichsregisterinhalte $e_k$ mit dem Vergleichsinhalt a gebildet. Dabei ergeben sich nun vier Übereinstimmungen nämlich an den Registern 14, 13, 1 und 0. Der Maximumzähler wird folglich im Schritt 47 auf 4 gesetzt und im Schritt 48 wird nunmehr das Register 13 als das Register mit der bisher höchsten Summe von Übereinstimmungen erkannt und mit dem Zeiger j zwischengespeichert.

In einem weiteren Programmdurchlauf über die Schleife 51 wird anschließend das Register 12 als neues Bezugsregister gewählt und dabei werden fünf Übereinstimmungen nämlich mit den Registern 14, 13, 12, 1 und 0 festgestellt. Der Maximumzähler $Z_{max}$ wird im Schritt 47 erneut erhöht. Dieser Vorgang wiederholt sich zunächst mit jedem neuen Programmdurchlauf über die Schleife 51. Beim Register 2 als Bezugsregister werden schließlich bei sämtlichen 15 Speicherregister 19 Übereinstimmung mit dem jeweiligen Vergleichsinhalt a festgestellt und der Maximumzähler wird im Schritt 47 auf 15 gesetzt. Im Schritt 48 wird das Register 2 als Register mit der maximalen Übereinstimmungszahl zwischengespeichert. Im Schritt 49 wird sodann das Register 1 also neues Bezugsregister gewählt und über die Schleife 51 wird jetzt nur noch eine Übereinstimmung, nämlich mit sich selbst festgestellt. Der Übereinstimmungszähler Z erreicht folglich nicht mehr ein neues Maximum, so daß nach dem Schritt 46 die Schritte 47 und 48 übersprungen werden und in einem letzten Durchlauf der Schleife 51 nunmehr das Register 0 als neues Bezugsregister gewählt wird. Auch hierfür ergibt sich kein neues Übereinstimmungsmaximum mit den Vergleichsregistern. Im Schritt 49 wird nunmehr der Zeiger i für das Bezugsregister um 1 dekrementiert und gelangt damit unter Null. Im Schritt 50 wird nun festgestellt, daß sämtliche Speicherregister 19 als Bezugsregister angewählt und jeweils mit den Vergleichsregistern in Beziehung gesetzt worden sind. Damit zeigt jetzt der im Schritt 48 zwischengespeicherte Zeiger j auf das Register mit der maximalen Übereinstimmungssumme—im Beispielsfall das Register 2. Es ist das Speicherregister 19, in welches der letzte Zählimpuls—im Beispielsfall der Impuls 43—eingelesen wurde. Im Schritt 52 wird nun vom Mikrocomputer 15 aus der Anzahl n (=15) der Speicherregister 19, dem Inhalt $e_i$ (=3) des Registers 2 mit der maximalen Übereinstimmungszahl $Z_{max}$ sowie aus der Stellung des Zeigers j (=2) auf das ermittelte Register 2 der Inhalt X des Speichers 19 nach folgender Formel ermittelt:

$$X = n \times e_j - j$$
$$X = 15 \times 3 - 2 = 43$$

Im Schritt 53 wird nun im Mikrocomputer 15 aus diesem Wert sowie aus dem Inhalt des Vorteilers 12 der Kilometerstand errechnet. Da nur alle zwei Kilometer ein Zählimpuls in den Speicher 19 eingeschrieben wird, muß folglich der ermittelte Wert X mit 2 multipliziert werden und je nach Zählerstand des Vorteilers 12 wird der errechnete Wert noch um 1 erhöht. Im Schritt 54 wird schließlich der so ermittelte Kilometerstand vom Mikrocomputer 15 auf dem Display 17 angezeigt.

Da die Speicherzellen eines EEPROM's als Speicher 19 nach den derzeitigen Herstellerangaben

nur bis zu 10 000 Überschreibungen gewährleisten und da ferner nach jedem 15. Zählimpuls die Speicherzellen der Register umlaufend gelöscht und neu beschrieben werden, ergibt sich im Ausführungsbeispiel eine maximale Anzahl von Zählimpulsereignissen X=150 000 und folglich ein maximaler Kilometerstand von 300 000 km. Sollte dies als unzureichend angesehen werden, so ist es ohne weiteres möglich, den maximalen Zählerstand dadurch zu erhöhen, daß beispielsweise der Vorteiler 12 im Mikrocomputer 15 nur alle drei Kilometer bzw. vier oder fünf Kilometer einen Zählimpuls an den Speicher 16 abgibt. Im Programmschritt 53 (Figur 5) muß dann dementsprechend der Speicherinhalt X zusammen mit dem Inhalt des Vorteilers 12 auf den richtigen Kilometerstand umgerechnet werden. Durch den Inhalt des Vorteilers 12 ist es ebenfalls möglich, bei dem Kilometerstand die erste Stelle hinter dem Komma auf dem Display 17 mit anzuzeigen. Ebenso kann in nicht dargestellter Weise ein Zusätzlicher Speicher bzw. ein entsprechendes Zählregister als Tageskilometerzähler verwendet werden, dessen Inhalt auf dem Display 17 anzuzeigen ist.

Mit der erfindungsgemäßen Schaltungsanordnung führen Fehler an einzelnen Speicherzellen allenfalls zu einer minimalen Abweichung des Speicherinhaltes um X=±1. Hat im Beispielsfall das Register 14—wie in Figur 3 in Klammern dargestellt—in der Speicherzelle 5 eine Fehlinformation (1), so ergibt sich an diesem Register 14 im binären Dualcode der fehlerhafte Inhalt e=19. Bei der Inhaltsermittlung durch das Flußdiagramm gemäß Figur 5 ergibt sich nun für das Register 14 als Bezugsregister nur mit sich selbst als Vergleichsregister eine Inhaltsübereinstimmung. Bei den anderen Speicherregistern 19 als Bezugsregister ist nun zwar die Summe Z der Übereinstimmungen mit den Vergleichsregistern jeweils um 1 reduziert, jedoch bleibt weiterehin das Register 2 dasjenige Bezugsregister mit den meisten Übereinstimmungen, so daß im Schritt 52 (Figur 5) über den unveränderten Inhalt $e_j$ dieses Registers der Speicherinhalt X korrekt ermittelt wird. Die Fehlinformation in der Speicherzelle führt in diesem Fall nicht zu einem falschen Ergebnis. Bei einem erneuten Überschreiben des Registers 14 wird nun der Inhalt der Speicherzelle 5 wieder korrigiert und der vorübergehend aufgetretene Fehler in dieser Speicherzelle hat lediglich vorübergehend zu einem um 1 geringeren Zählerstand des Maximumzählers $Z_{max}$ geführt, was jedoch auf den errechneten Speicherinhalt X keinereil Einfluß hat.

Entsprechendes gilt auch für fehlerhafte Informationen in weiteren Speicherzellen der übrigen Speicherregister 19 mit Ausnahme der beiden Register, zwischen denen der Registerinhalt e um eine Einheit differiert. Dies sind im Beispielsfall beim Speicherinhalt X=43 die Register 1 und 2. Tritt beispielsweise am Register 2 in der fünften Speicherzelle eine Fehlinformation auf, so würde jetzt im Programmdurchlauf nach Figur 5 das Register 2 als Bezugsregister lediglich mit sich selbst als Vergleichsregister eine Übereinstimmung aufweisen. Die maximale Übereinstimmung von Z=14 würde jetzt beim Register 3 als Bezugsregister auftreten. Dadurch ergibt sich im Programmschritt 52 für den Speicherinhalt X ein Fehler von −1, da der 43. Zählimpuls, der im Register 3 eingelesen wurde nun nicht mehr erfaßt werden kann. Eine Fehlanzeige von +1 würde sich im Beispielsfall dann ergeben, wenn im Register 1 an der Speicherzelle 1 eine Fehlinformation auftritt, so daß der Inhalt e=2 dieses Registers nunmehr auf 3 erhöht ist. Nach dem Flußdiagramm gemäß Figur 5 würde nunmehr das Register 1 als Bezugsregister die größte Summe an Übereinstimmungen mit den Vergleichsregistern erzielen und im Programmschritt 52 zur Ermittlung des Speicherinhaltes X würde über dieses Register 1 ein Zählimpuls zuviel ermittelt werden.

Nach dem Ausführungsbeispiel werden die einzelnen Zählimpulse nach einem binären Dualcode umlaufend in die Speicherregister 19 eingelesen. Anstelle eines Dualcodes kann auch ein anderer Binärcode verwendet werden. Dabei ist lediglich darauf zu achten, daß der verwendete Code nicht nur zum Abspeichern der Zählimpulse sodern auch zum Abfragen der Registerinhalte verwendet wird. Verwendet man einen größeren Speicher 16, beispielsweise ein 64×16-bit-EEPROM, so kann der Speicherinhalt auf 640 000 Zählimpulse erweitert werden. Die Anwendung der erfindungsgemäßen Schaltungsanordnung ist daher auch nicht auf Kilometerzähler von Kraftfahrzeugen beschränkt, sondern allgemein als elektronische Zählschaltung verwendbar. Folglich können mit einer solchen Schaltungsanordnung auch Betriebszeitzähler, Mengenzähler. Durchflußzähler oder dergleichen realisiert werden, deren Inhalt über eine Zeit von mindestens 10 Jahren nicht verloren geht und deren Inhaltsgenauigkeit bis auf eine Abweichung von maximal einer Einheit pro Fehlinformation in einzelnen Zellen des Speichers 16 begrenzt ist.

**Patentansprüche**

1. Schaltungsanordnung zur Addition, Speicherung und Wiedergabe von elektrischen Zählimpulsen, vorzugsweise von einem Signalgeber (10), der Impulse abgibt, welche direkt oder über einen Impulsteiler (12) als Zählimpulse in einem einschrittigen Code in einer Anzahl von Speicherregistern (19) eines überschreibbaren, nichtflüchtigen Speichers (16) eingeschrieben werden und dessen Inhalt als Summe der Zählimpulse aus dem Speicher zyklisch ausgelesen sowie über ein Display optisch angezeigt wird, dadurch gekennzeichnet,

a) daß in der Schaltungsanordnung eine Steuerschaltung (13) vorgesehen ist, die beginnend mit dem ersten Speicherregister (19) jeden neuen Zählimpuls ($I_z$) in das nächstfolgende Speicherregister (19) einschreibt,

b) daß nach dem Erreichen des letzten Speicherregisters (19) die Steuerschaltung (13) mit

den nächsten Zählimpulsen ($I_z$) den Inhalt des ersten und danach des jeweils nächstfolgenden Speicherregisters (19) um je eine Einheit erhöht,

c) und daß die Steuerschaltung (13) ferner beim zyklischen Auslesen des Inhaltes (X) des Speichers (16) durch den Inhalt ($e_j$) und die Stelle (j) desjenigen Speicherregisters (19), in das der letzte Zählimpuls ($I_z$) eingeschrieben wurde, nach einem Algorithmus die Summe der eingeschreibenen Zählimpulse ($I_z$) ermittelt.

2. Schaltungsanordnung nach Anspruch 1, dadurch gekennzeichnet, daß die Steuerschaltung (13) die Zählimpulse ($I_z$) nach einem Binärcode in die einzelnen Speicherregister (19) einschreibt.

3. Schaltungsanordnung nach Anspruch 1 oder 2, dadurch gekennzeichnet, daß der Speicher (16) ein 16×16-EEPROM ist, welches in 16 Speicherregistern (19) mit je 16 Speicherplätzen (bit) aufgegliedert und über Steuerleitungen (18) mit der Steuerschaltung (13) sowie mit einer Datenein- und -ausgabeeinheit (14) verbunden ist.

4. Schaltungsanordnung nach einem der vorherigen Ansprüche, dadurch gekennzeichnet, daß die Steuerschaltung (13) beim zyklischen Auslesen des Inhaltes (X) des Speichers (16) durch Vergleich des Inhaltes (e) der einzelnen Speicherregister (19) untereinander dasjenige Speicherregister (19) ermittelt, in welches der letzte Zählimpuls ($I_z$) eingeschrieben wurde.

5. Schaltungsanordnung nach Anspruch 4, dadurch gekennzeichnet, daß die Steuerschaltung (13) schrittweise fortschreitend den Inhalt jeweils eines der Speicherregister (1) als Bezugsregister (i) mit dem Inhalt aller Speicherregister (19) als Vergleichsregister (k), beginnend mit dem ersten und abschließend mit dem letzten Speicherregister (19) vergleicht, daß sie den Inhalt ($e_k$) der Vergleichsregister (k), die dem Bezugsregister nachgeordnet sind, mit einem um eine 1 dekrementierten Vergleichsinhalt (a) des Bezugsregisters (i) vergleicht und daß sie bei den Vergleichen die Summe (Z) der Übereinstimmungen bildet und zwischenspeichert.

6. Schaltungsanordnung nach Anspruch 5, dadurch gekennzeichnet, daß die Steuerschaltung (13) die Übereinstimmungssumme (Z) die dem jeweils aufgerufenen Bezugsregister (i) zugeordnet ist, mit der größten Übereinstimmungssumme ($Z_{max}$) vergleicht, die einem zuvor aufgerufenen Bezugsregister (j) zugeordnet ist, und dasjenige Bezugsregister (j) mit der maximalen Übereinstimmungssumme ($Z_{max}$) ermittelt, zwischenspeichert sowie über dessen Inhalt ($e_j$) die Summe der im Speicher (16) eingeslesenen Zählimpulse ($I_z$) feststellt.

7. Schaltungsanordnung nach einem der vorherigen Ansprüche, dadurch gekennzeichnet, daß die Steuerschaltung (13) die Zählimpulse ($I_z$) im Dualcode in die einzelnen Speicherregister (19) einschreibt.

8. Schaltungsanordnung nach einem der vorherigen Ansprüche, dadurch gekennzeichnet, daß die Steuerschaltung (13) sowie die Datenein- und -ausgabeeinheit (14) in einem Mikrocomputer (15) zusammengefaßt sind.

9. Schaltungsanordnung nach einem der vorherigen Ansprüche, dadurch gekennzeichnet, daß dem Signalgeber (10) ein Vorteiler (12) nachgeschaltet ist, mit dem die Signale des Signalgebers auf die Zählimpulse ($I_z$) für den Speicher (16) heruntergeteilt werden.

**Revendications**

1. Dispositif de circuit pour l'addition, la mémorisation et la reproduction d'impulsions électriques de comptage, de préférence en provenance d'un émetteur de signaux (10) qui délivre des impulsions qui sont inscrites directement ou bien par l'intermédiaire d'un diviseur d'impulsions (12) en tant qu'impulsions de comptage selon un code cyclique dans un certain nombre de registres de mémoire (19) d'une mémoire (16) non volatile et surchargeable, et dont le contenu est extrait cycliquement de la mémoire sous la forme d'une somme des impulsions de comptage, et est affiché optiquement par l'intermédiaire d'un affichage, dispositif de circuit caractérisé en ce que:

a) il est prévu, dans ce dispositif de circuit, un circuit de commande (13) qui inscrit au début avec le premier registre de mémoire (19) chaque nouvelle impulsion de comptage ($I_z$) dans le registre de mémoire (19) immédiatement suivant,

b) après que le dernier registre de mémoire (19) ait été atteint, le circuit de commande (13) augmente respectivement d'une unité, avec les impulsions de comptage suivantes ($I_z$), le contenu du premier register de mémoire (19) et ensuite le contenu des registres de mémoire respectifs (19) immédiatement suivants,

c) le circuit de commande (13), lors de l'extraction cyclique du contenu (X) de la mémoire (16), détermine en outre, d'après un algorithme, la somme des impulsions de comptage ($I_z$) inscrites, par l'intermédiaire du contenu ($e_j$) et de l'emplacement (j) du registre de mémoire (19) dans lequel a été inscrite la dernière impulsion de comptage ($I_z$).

2. Dispositif de circuit selon la revendication 1, caractérisé en ce que le circuit de commande (13) inscrit les impulsions de comptage ($I_z$) selon un code binaire dans les différents registres de mémoire (19).

3. Dispositif de circuit selon la revendication 1 ou la revendication 2, caractérisé en ce que la mémoire (16) est une EEPROM de 16×16 chiffres binaires, qui est articulée en 16 registres de mémoire (19) comportant chacun 16 places de mémoire (chiffres binaires), et qui est reliée par l'intermédiaire de liaisons de commande (18) avec le circuit de commande (13) ainsi qu'avec une unité d'entrée et de sortie de données (14).

4. Dispositif de circuit selon une des précédentes revendications, caractérisé en ce que le circuit de commande (13), lors de l'extraction cyclique du contenu (X) de la mémoire (16), détermine par comparaison entre des contenus (e) des différents registres de mémoire (19), le registre de mémoire (19) dans lequel a été inscrite la dernière impulsion de comptage ($I_z$).

5. Dispositif de circuit selon la revendication 4,

caractérisé en ce que le circuit de commande (13) compare en progressant pas à pas le contenu de respectivement un des registres de mémoire (19) jouant le rôle de registre de référence (i) avec le contenu de tous les registres de mémoire (19) jouant le rôle de registres de comparaison (k), en commençant par le premier et en terminant par le dernier registre de mémoire (19), en ce que ce circuit de commande compare le contenu ($e_k$) des registres de comparaison (k) qui sont disposés à la suite du registre de référence, avec un contenu de comparaison (a) décrémenté de 1 du registre de référence (i) et en ce que ce circuit de commande forme lors de cette comparaison, la somme (Z) des coïncidences et la mémorise temporairement.

6. Dispositif de circuit selon la revendication 5, caractérisé en ce que le circuit de commande (13) compare la somme des coïncidences (Z) qui est associée au registre de référence (i) respectivement appelé avec la somme maximale des coïncidences ($Z_{max}$), qui est associée à un registre de référence (j) appelé précédemment, et ce circuit de commande détermine le registre de référence (j) comportant la somme maximale de coïncidences ($Z_{max}$), le mémorise temporairement et détermine, par l'intermédiaire de son contenu ($e_j$) la somme des impulsions de comptage ($I_z$) introduite dans la mémoire (16).

7. Dispositif de circuit selon un des précédentes, revendications, caractérisé en ce que le circuit de commande (13) inscrit les impulsions de comptage ($I_z$) selon un code dual dans les différents registres de mémoire (19).

8. Dispositif de circuit selon une des précédentes revendications, caractérisé en ce que le circuit de commande (13) ainsi que l'unité d'entrée et de sortie de données (14) sont rassemblés dans un microcalculateur (15).

9. Dispositif de circuit selon une des précédentes revendications, caractérisé en ce qu'un répartiteur (12) est branché à la suite de l'émetteur de signaux (10) répartiteur grâce auquel les signaux de l'émetteur de signaux sont répartis sur les impulsions de comptage ($I_z$) pour la mémoire (16).

## Claims

1. Circuit arrangement for the addition, storage and reproduction of electrical counting pulses, preferably from a signal transmitter (10) which issues pulses which are written in a unit-distance code into a number of memory registers (19) of an overwrittable, non-volatile memory (16) and the contents of which are read out cyclically from the memory as the total of the counting pulses and are visually displayed via a display, characterized in that

a) a control circuit (13) is provided in the circuit arrangement which, beginning with the first memory register (19) writes each new counting pulse ($I_z$) into the subsequent memory register (19),

b) after reaching the last memory register (19) the control circuit (13) with the next counting pulses ($I_z$) increases the contents of the first and then of each subsequent memory register (19) by one unit,

c) also during the cyclical reading out of the contents (X) of the memory (16) the control circuit (13) determines according to an algorithm the total of the counting pulses ($I_z$) written in by means of the contents ($e_j$) and the position (j) of the memory register (19) into which the last counting pulse ($I_z$) was written.

2. Circuit arrangement according to Claim 1, characterized in that the control circuit (13) writes the counting pulses ($I_z$) into the individual memory registers (19) according to a binary code.

3. Circuit arrangement according to Claim 1 or 2, characterized in that the memory (16) is a 16×16 EEPROM which is divided up into 16 memory registers (19) each having 16 memory locations (bit) and is connected via control lines (18) to the control circuit (13) and to a data input and output unit (14).

4. Circuit arrangement according to one of the preceding claims, characterized in that the control circuit (13) determines, during the cyclical reading out of the contents (X) of the memory (16) by means of comparing the contents (e) of the individual memory registers (19) with one another, the memory register (19) into which the last counting pulse ($I_z$) has been written.

5. Circuit arrangement according to Claim 4, characterized in that the control circuit (13) progressively compares in steps the contents of, in each case, one of the memory registers (19) as a reference register (i) with the contents of all the memory registers (19) as comparison register (k), beginning with the first and ending with the last memory register (19), in that said circuit arrangement compares the contents ($e_k$) of the comparison registers (k) which are subordinate to the reference register with the comparison contents (a), decremented by a 1, of the reference register (i) and in that during the comparisons said circuit arrangement forms the total (Z) of the correspondences and intermediately stores it.

6. Circuit arrangement according to Claim 5, characterized in that the control circuit (13) compares the correspondence total (Z) which is associated with the reference register (i) called up in each case with the greatest correspondence total ($Z_{max}$) which is associated with a previously called up reference register (j) and determines the reference register (j) with the maximum correspondence total ($Z_{max}$), intermediately stores it and via its contents ($e_j$) establishes the total of the counting pulses ($I_z$) read into the memory (16).

7. Circuit arrangement according to one of the preceding claims, characterized in that the control circuit (13) writes the counting pulses ($I_z$) into the individual memory registers (19) in dual code.

8. Circuit arrangement according to one of the preceding claims, characterized in that the control circuit (13) and the data input and output unit (14) are combined in one microcomputer (15).

9. Circuit arrangement according to one of the

preceding claims, characterized in that connected downstream of the signal transmitter (10) there is a prescaler (12), with which the signals of the signal transmitter are divided down to form the counting pulses ($I_z$) for the memory (16).

FIG.1

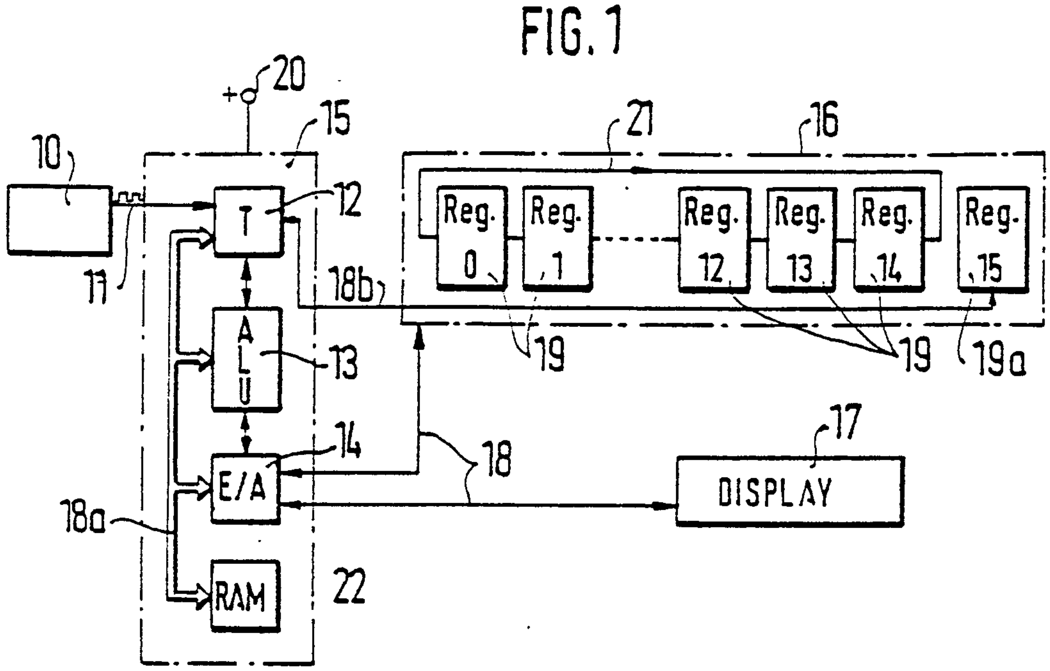
20
15
21
16
10
12
T
Reg. 0
Reg. 1
Reg. 12
Reg. 13
Reg. 14
Reg. 15
11
18b
A L U
13
19
19
19a
14
E/A
18
17
DISPLAY
18a
RAM
22

FIG.4

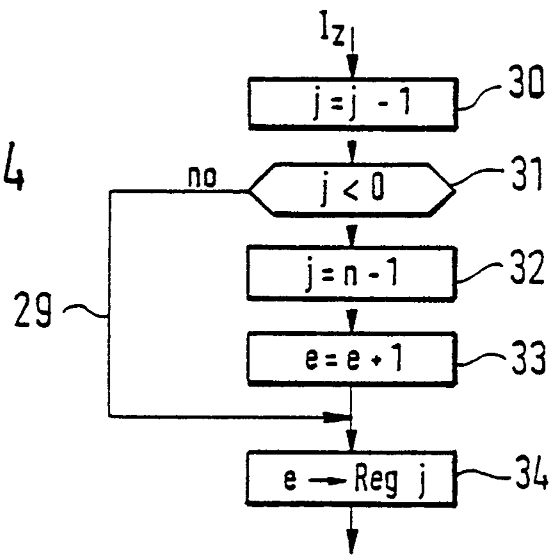
Iz
j=j -1
30
no
j < 0
31
j=n-1
32
29
e=e+1
33
e → Reg j
34

FIG. 2

| $I_z$ | Reg. 0 | 1 | 2 | ....... | 10 | 11 | 12 | 13 | 14 |
|---|---|---|---|---|---|---|---|---|---|
| 0 | 0 | 0 | 0 | | 0 | 0 | 0 | 0 | 0 |
| 1 | 0 | 0 | 0 | | 0 | 0 | 0 | 0 | 1 |
| 2 | 0 | 0 | 0 | | 0 | 0 | 0 | 1 | 1 |
| 3 | 0 | 0 | 0 | | 0 | 0 | 1 | 1 | 1 |
| 4 | 0 | 0 | 0 | | 0 | 1 | 1 | 1 | 1 |
| 5 | 0 | 0 | 0 | | 1 | 1 | 1 | 1 | 1 |
| ≈ | | | | | | | | | |
| 13 | 0 | 0 | 1 | | 1 | 1 | 1 | 1 | 1 |
| 14 | 0 | 1 | 1 | | 1 | 1 | 1 | 1 | 1 |
| 15 | 1 | 1 | 1 | | 1 | 1 | 1 | 1 | 1 |
| 16 | 1 | 1 | 1 | | 1 | 1 | 1 | 1 | 2 |
| 17 | 1 | 1 | 1 | | 1 | 1 | 1 | 2 | 2 |
| 18 | 1 | 1 | 1 | | 1 | 1 | 2 | 2 | 2 |
| 19 | 1 | 1 | 1 | | 1 | 2 | 2 | 2 | 2 |
| ≈ | | | | | | | | | |
| ⇒ 43 | 2 | 2 | 3 | | 3 | 3 | 3 | 3 | 3 |
| ⋮ | | | | | | | | | |

FIG. 3

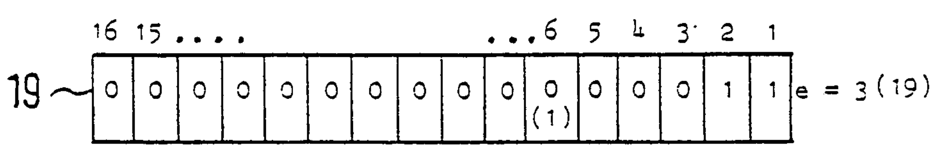

FIG. 5

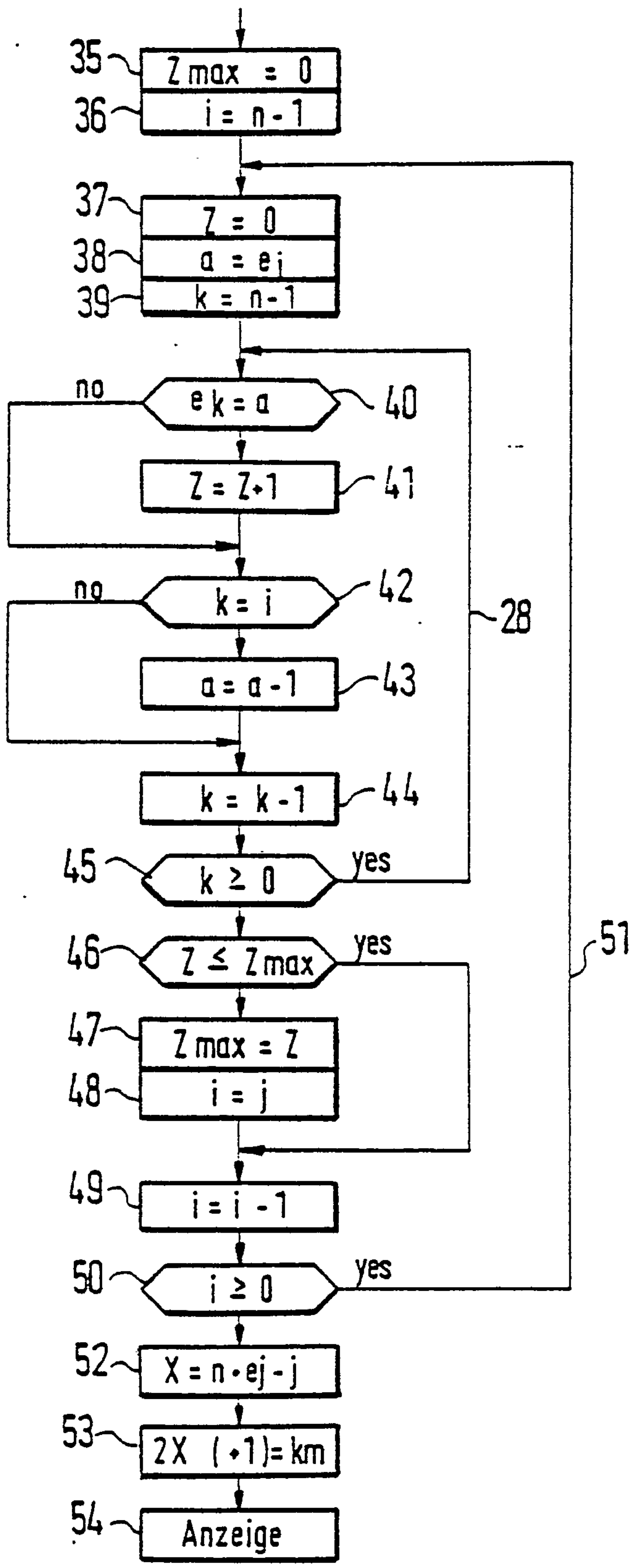
35
Zmax = 0
36
i = n - 1
37
Z = 0
38
a = ej
39
k = n - 1
no
ek = a
40
Z = Z+1
41
no
k = i
42
a = a - 1
43
28
k = k - 1
44
45
k ≥ 0
yes
46
Z ≤ Zmax
yes
51
47
Zmax = Z
48
i = j
49
i = i - 1
50
i ≥ 0
yes
52
X = n • ej - j
53
2X (+1)= km
54
Anzeige